# EUROPÄISCHE PATENTSCHRIFT

(11) **EP 2 175 707 B1**
(45) Veröffentlichungstag und Bekanntmachung des Hinweises auf die Patenterteilung: **17.02.2016**
(21) Anmeldenummer: 09011744.1
(22) Anmeldetag: 15.09.2009
(51) Int. Cl.: H05K 5/02, G01D 11/24

(54) **Gehäuse für ein elektrisches oder elektronisches Gerät**
Housing for an electrical or electronic device
Boîtier pour un appareil électrique ou électronique

(30) Priorität: 10.10.2008 DE 102008050914; 11.11.2008 DE 102008056817
(43) Veröffentlichungstag der Anmeldung: 14.04.2010
(73) Patentinhaber: KROHNE MESSTECHNIK GMBH & CO. KG, 47058 Duisburg (DE)
(72) Erfinder: Dr. Hoeland, Karsten, 44801 Bochum (DE); Matt, Achim, 47055 Duisburg (DE); Schulze, Sebastian, 06484 Quedlinburg (DE)
(74) Vertreter: Gesthuysen Patent- und Rechtsanwälte

(56) Entgegenhaltungen:
- WO-A1-2004/017026
- WO-A1-2007/090421
- WO-A2-2006/030004
- DE-A1- 10 108 199

## Beschreibung

Die Erfindung betrifft ein Gehäuse für ein elektrisches oder elektronisches Gerät mit mindestens zwei - elektrische und/oder elektronische Bauelemente, Bauteile, Bauelementegruppen und/oder Bauteilegruppen in ihren Innenräumen aufnehmende - Aufnahmeteilen und mit mindestens einem mindestens ein Aufnahmeteil verschließenden Verschlussteil, wobei in jedem Aufnahmeteil eine eine eigene Funktionstüchtigkeit aufweisende Funktionseinheit vorgesehen sein kann.
Im Rahmen der Erfindung soll "elektrisches oder elektronisches Gerät" ganz allgemein verstanden werden. Ob ein elektrisches Gerät oder ein elektronisches Gerät vorliegt, ist häufig nicht eindeutig bestimmbar. Weist ein solches Gerät nur - in der Regel konventionelle - elektrische Bauelemente, Bauteile, Bauelementegruppen und/oder Bauteilegruppen auf, so wird man in der Regel von einem elektrischen Gerät sprechen. Demgegenüber wird man in der Regel von einem elektronischen Gerät sprechen, wenn es - ausschließlich, fast ausschließlich oder überwiegend - elektronische Bauelemente, Bauteile, Bauelementegruppen und/oder Bauteilegruppen aufweist. Häufig wird auch funktional zwischen einem elektrischen Gerät und einem elektronischen Gerät unterschieden. Elektrische Geräte sind häufig solche, die sich funktional eher konservativ darstellen. Demgegenüber spricht man häufig von elektronischen Geräten, wenn sie sich funktional modern darstellen, insbesondere wenn in ihnen im weitesten Sinne Halbleitertechnologie verwendet ist.

Im Rahmen der Erfindung soll unter einem elektrischen oder elektronischen Gerät auch ein solches verstanden werden, dessen Funktionalität mehrgliedrig realisiert ist, bei dem also gleichsam zwei oder mehrere Geräte vorliegen, die sich funktional ergänzen, die gewollte Funktionstüchtigkeit also nur im Zusammenwirken der einzelnen Geräte gewollt ist und erreicht wird.

Das Gehäuse, mit dem sich die Erfindung beschäftigt, kann nun ein solches sein, das in seinem Innenraum alle für die Funktionstüchtigkeit des entsprechenden elektrischen oder elektronischen Geräts erforderlichen elektrischen und/oder elektronischen Bauelemente, Bauteile, Bauelementegruppen und/ oder Bauteilegruppen aufnimmt, das also mit den in seinem Innenraum vorgesehenen elektrischen und/oder elektronischen Bauelementen, Bauteilen, Bauelementegruppen und/oder Bauteilegruppen ein funktionstüchtiges elektrisches oder elektronisches Gerät darstellt. Jedoch kann das Gehäuse, mit dem sich die Erfindung beschäftigt, auch ein solches sein, das im Sinne des zuvor angesprochenen mehrgliedrigen Aufbaus eines elektrischen oder elektronischen Geräts in seinem Innenraum nur einen Teil der für die Funktionstüchtigkeit erforderlichen elektrischen und/oder elektronischen Bauelemente, Bauteile, Bauelementegruppen und/oder Bauteilegruppen aufnimmt, - so daß funktionsnotwendig weitere elektrische und/oder elektronische Bauelemente, Bauteile, Bauelementegruppen und/oder Bauteilegruppen anderweitig untergebracht sind, möglicherweise wieder in einem entsprechenden Gehäuse, möglicherweise aber auch an ganz anderer Stelle, räumlich mehr oder weniger stark getrennt.

Eingangs ist gesagt worden, daß es erfindungsgemäß um ein Gehäuse für ein elektrisches oder elektronisches Gerät mit mindestens einem Aufnahmeteil und mit mindestens einem Verschlußteil geht. Die Formulierung "mit" macht deutlich, daß es, im Gegensatz zu einer Formulierung "bestehend aus", nicht um eine enumerative Aufzählung geht. Das Gehäuse, mit dem sich die Erfindung beschäftigt, kann also einerseits mehrere Aufnahmeteile, andererseits mehrere Verschlußteile aufweisen, - möglich ist aber auch, daß neben einem Aufnahmeteile oder mehreren Aufnahmeteilen und neben einem Verschlußteil oder mehreren Verschlußteilen noch andere Funktionsteile verwirklicht sind.

Weist das in Rede stehende Gehäuse mehrere Aufnahmeteile auf, so können die Aufnahmeteile entweder mehrere Innenräume oder aber auch nur einen - aus zwei oder mehreren Aufnahmeteilen gebildeten - Innenraum realisieren. Die Realisierung mehrerer Innenräume, die dann in unterschiedlicher Weise voneinander getrennt bzw. abgetrennt sein können oder gar müssen, hängt häufig insbesondere vom Einsatz des entsprechenden elektrischen oder elektronischen Geräts ab, häufig auch davon, welche elektrischen und/oder elektronischen Bauelemente, Bauteile, Bauelementegruppen und/oder Bauteilegruppen aufzunehmen sind, welche Spannungen und welche Ströme auftreten, ob innerhalb des Gehäuses in erheblichem Maße elektrische Energie in Wärme umgesetzt wird und/oder ob bei dem entsprechenden elektrischen oder elektronischen Gerät ein Explosionsschutz realisiert sein muß.

Ein Gehäuse für ein elektrisches oder elektronisches Gerät muß natürlich so ausgeführt sein, daß elektrische Kabel und/oder Leitungen in das Gehäuse hereingeführt und/oder aus dem Gehäuse herausgeführt werden können. Diese Möglichkeit kann man am Aufnahmeteil realisieren, man kann sie aber auch - und häufig geschieht das auch - am Verschlußteil realisieren.

Weist das in Rede stehende Gehäuse zwei oder mehrere Verschlußteile auf, so können diese Verschlußteile funktional unterschiedlich ausgeführt sein. Sind zwei Verschlußteile vorgesehen, so können beide Verschlußteile die ausschließliche Funktion des Verschließens des Innenraumes des Aufnahmeteils haben; bei dieser Ausführungsform muß dann im Bereich des Aufnahmeteils das Hereinführen und Herausführen elektrischer Kabel und/oder Leitungen realisiert sein. Sind zwei Verschlußteile realisiert, so kann ein Verschlußteil nur die Funktion des Verschließens des Innenraums des Aufnahmeteils haben, während das zweite Verschlußteil eine doppelte Funktion haben kann, einerseits die des Verschließens des Innenraums des Aufnahmeteils, andererseits die des Hereinführens und Herausführen elektrischer Kabel und/oder Leitungen. Bei einer Ausführungsform mit zwei Verschlußteilen können auch beide Verschlußteile die zuvor erläuterte doppelte Funktion haben. Das, was zuvor in bezug auf zwei Verschlußteile ausgeführt worden ist, gilt entsprechend auch dann, wenn mehr als zwei Verschlußteile realisiert sind.

Im folgenden soll der Begriff Verschlußteil immer dann verwendet werden, wenn damit zumindest auch der Innenraum des Aufnahmeteils, der Innenraum von zwei Aufnahmeteilen oder die Innenräume mindestens eines Aufnahmeteils - ganz oder teilweise - verschlossen bzw. abgeschlossen wird.

Geometrisch-räumlich kann bei dem Gehäuse, mit dem sich die Erfindung beschäftigt, das Aufnahmeteil und das Verschlußteil ganz unterschiedlich ausgeführt sein, wobei die geometrisch-räumliche Ausführung des Verschlußteils bzw. der Verschlußteile natürlich unter Berücksichtigung der geometrischräumlichen Ausführung des Aufnahmeteils erfolgen muß.

Vorzugsweise ist das Aufnahmeteil bzw. sind die Aufnahmeteile zylindrisch ausgeführt, insbesondere kreiszylindrisch. Das schließt nicht aus, daß das Aufnahmeteil sich einseitig oder beidseitig verjüngt oder daß sich die Aufnahmeteile zumindest einseitig verjüngen.

Bei einer bevorzugten Ausführungsform des Gehäuses, mit dem sich die Erfindung beschäftigt, sind zwei Aufnahmeteile verwirklicht, wobei das zweite Aufnahmeteil domartig auf dem ersten Aufnahmeteil angeordnet ist.

Gehäuse für elektrische oder elektronische Geräte der zuvor beschriebenen Art sind in verschiedenen Ausführungsformen bekannt, insbesondere aus der deutschen Offenlegungsschrift 101 26 654 und aus der PCT-Offenlegungsschrift WO 2004/017025.

Bei Gehäusen der in Rede stehenden Art erfolgt die mechanische Verbindung des Verschlußteils bzw. der Verschlußteile mit dem Aufnahmeteil bzw., wenn mehrere Aufnahmeteile verwirklicht sind, die mechanische Verbindung der Aufnahmeteile untereinander und die Verbindung des Verschlußteils mit einem Aufnahmeteil oder die Verbindung der Verschlußteile mit den Aufnahmeteilen durch eine Verschraubung. Das ist nicht frei von Nachteilen, weil einerseits das Verschrauben relativ zeitaufwendig ist, weil andererseits, verwendet man nicht Schraubendreher mit vorgegebenem Drehmoment, die mechanische Verbindung in ihrer Wirksamkeit von der Sorgfalt desjenigen abhängt, der manuell die Verbindung herstellt.

Aus der WO 2007/090421 ist ein modular aufgebautes Feldgerät für die Prozessinstrumentierung bekannt. Die verschiedenen Module des Feldgerätes sind mit einem Bajonettverschluss miteinander verbunden.

Der Erfindung liegt nun die Aufgabe zugrunde, ein Gehäuse für ein elektrisches oder elektronisches Gerät anzugeben, bei dem die zuvor erläuterte mechanische Verbindung des Verschlußteils bzw. der Verschlußteile mit dem Aufnahmeteil bzw. mit den Aufnahmeteile besonders einfach und gut reproduzierbar durchgeführt werden kann.

Das erfindungsgemäße Gehäuse, bei dem die zuvor hergeleitete und aufgezeigte Aufgabe gelöst ist, ist nun zunächst und im wesentlichen dadurch gekennzeichnet, dass zwischen den Aufnahmeteile sowie zwischen mindestens einem Aufnahmeteil und dem Verschlussteil oder den Verschlussteilen jeweils ein Bajonettverschluss realisiert ist, dass der Bajonettverschluss aus einem ersten Bajonettteil und einem zweiten Bajonettteil besteht, dass der Bajonettverschluss am ersten Bajonettteil über den Umfang verteilt abwechselnd eine in der Ebene senkrecht zur Steckrichtung senkrecht verlaufende Grundfläche, eine sich an die Grundfläche anschließende Schrägfläche und eine sich an das obere Ende der Schrägfläche anschließende, zur Steckrichtung senkrecht verlaufende Kopffläche aufweist und dass der senkrecht zur Steckrichtung verlaufenden Kopffläche am ersten Bajonettteil am zweiten Bajonettteil eine senkrecht zur Steckrichtung verlaufende Gegenfläche zugeordnet ist. (Zu dem, was man unter einem Bajonettverschluß versteht, kann auf verschiedene Literaturstellen verwiesen werden, insbesondere auch auf "Wikipedia, die freie Enzyklopädie".)

Bei einem üblichen Bajonettverschluß wird ein Teil über den anderen geschoben. Der eine Teil, der über den anderen geschoben wird, besitzt einen Längsschlitz, an dessen Ende sich rechtwinklig ein kurzer Querschlitz ansetzt. Der andere Teil besitzt dagegen einen Knopf, der in den Querschlitz eingeführt wird und dann die feste Verbindung bewirkt. Die Verbindung erfolgt also über eine Steck-Drehbewegung. Die beiden zu verbindenden Teile werden ineinandergesetzt; annähernd senkrecht zur Steckrichtung sind in beiden Teilen an der Verbindungsstelle längliche Erhebungen angebracht. Diese laufen jedoch nicht rundum, sondern sind unterbrochen (sonst wäre das Ineinanderstecken nicht möglich). Da nun die Erhebungen leicht schräg in der Ebene senkrecht zur Steckrichtung liegen, werden durch eine Drehbewegung beide Teile gegeneinander gepreßt. Der Bajonettverschluß arbeitet also wie ein Gewinde.

Das, was zuvor in bezug auf einen normalen Bajonettverschluß ausgeführt worden ist, hat in bezug auf das erfindungsgemäße Gehäuse einen Nachteil, daß nämlich zwischen den beiden Teilen, vorliegend also zwischen dem Verschlußteil und dem Aufnahmeteil bzw. zwischen den Verschlußteilen und den Aufnahmeteilen ein Spalt verbleibt, der über den Umfang nicht gleich ist.

Bei einer bevorzugten Ausführungsform des erfindungsgemäßen Gehäuses ist deshalb ein "besonderer" Bajonettverschluß verwirklicht, nämlich ein solcher, bei dem in der Verbindungsposition immer ein gleicher Spalt realisiert ist, vorzugsweise immer ein Spalt mit der Spaltweite Null.

Erfindungsgemäß ist vorgesehen, daß der Bajonettverschluß, der aus einem ersten Bajonettteil und einem zweiten Bajonetteil besteht, am ersten Bajonettteil über den Umfang verteilt abwechselnd eine in der Ebene senkrecht zur Steckrichtung senkrecht verlaufende Grundfläche, eine sich an die Grundfläche anschließende Schrägfläche und eine sich an das obere Ende der Schrägfläche anschließende, zur Steckrichtung senkrecht verlaufende Kopffläche aufweist. Der senkrecht zur Steckrichtung verlaufenden Kopffläche am ersten Bajonettteil ist dann am zweiten Bajonettteil eine ebenfalls senkrecht zur Steckrichtung verlaufende Gegenfläche zugeordnet.

In der Verbindungsposition liegt dann die Gegenfläche des zweiten Bajonettteils an der Kopffläche des ersten Bajonettteils an. Es korrespondieren dann also zwei senkrecht zur Steckrichtung verlaufende Flächen, nämlich die Gegenfläche am zweiten Bajonettteil und die Kopffläche am ersten Bajonettteil. Daraus resultiert - über den Umfang insgesamt gesehen - immer ein gleicher Spalt, vorzugsweise ein Spalt mit der Spaltweite Null.

Weiter oben ist ausgeführt worden, daß bei einem üblichen Bajonettverschluß die Erhebungen leicht schräg in der Ebene senkrecht zur Steckrichtung liegen, so daß durch eine Drehbewegung beide Teile gegeneinander gepreßt werden, der Bajonettverschluß also wie ein Gewinde arbeitet. Von dieser Betrachtung ausgehend gilt auch für das erfindungsgemäße Gehäuse, daß der dort verwirklichte Bajonettverschluß zunächst wie ein Gewinde arbeitet, danach, vor dem Erreichen der Verbindungsposition, spätestens aber mit dem Erreichen der Verbindungsposition, ein gewindemäßiges Arbeiten nicht mehr gegeben ist, weil nämlich sowohl die am ersten Bajonettteil verwirklichte Kopffläche als auch die am zweiten Bajonettteil verwirklichte Gegenfläche senkrecht zur Steckrichtung verlaufen, also nicht schräg zur Steckrichtung verlaufen.

Einleitend ist ausgeführt worden,
daß im Rahmen der Erfindung unter einem elektrischen oder elektronischen Gehäuse auch ein solches verstanden werden soll, dessen Funktionalität mehrgliedrig realisiert ist, bei dem also gleichsam zwei oder mehrere Geräte vorliegen, die sich funktional ergänzen, die gewollte Funktionstüchtigkeit also nur im Zusammenhang der einzelnen Geräte gewollt ist und erreicht wird,
daß das erfindungsgemäße Gehäuse einerseits mehrere Aufnahmeteile, andererseits mehrere Verschlußteile aufweisen kann, und
daß dann, wenn das in Rede stehende Gehäuse mehrere Aufnahmeteile aufweist, die Aufnahmeteile entweder mehrere Innenräume oder aber auch nur einen - aus zwei oder mehreren Aufnahmeteile gebildeten - Innenraum realisieren können, wobei mehrere Innenräume in unterschiedlicher Weise voneinander getrennt bzw. abgetrennt sein können oder gar müssen.

Im einzelnen gibt es nun verschiedene Möglichkeiten, das erfindungsgemäße Gehäuse auszugestalten und weiterzubilden. Dazu wird auf die dem Patentanspruch 1 nachgeordneten Patentansprüche und auf die nachfolgende Beschreibung eines Ausführungsbeispiels in Verbindung mit der Zeichnung verwiesen. In der Zeichnung zeigen
- Fig. 1: ein bevorzugtes Ausführungsbeispiel eines erfindungsgemäßen Gehäuses für ein elektrisches oder elektronisches Gerät,
- Fig. 2: das Gehäuse nach Fig. 1, in einer Sprengdarstellung,

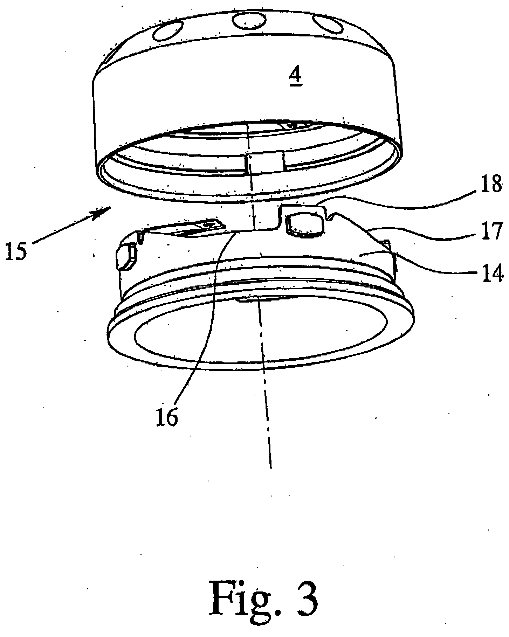

- Fig. 3: in gegenüber der Fig. 2 vergrößerter Darstellung, den oberen Bereich des in Fig. 2 dargestellten Gehäuses,

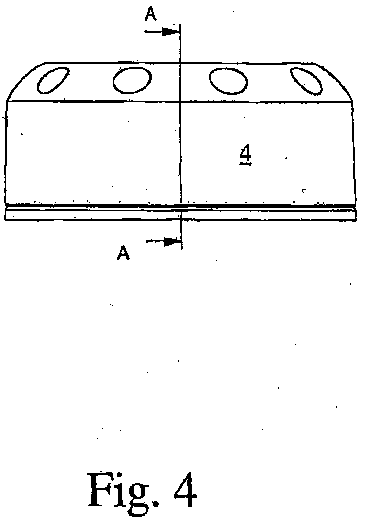

- Fig. 4: eine Seitenansicht eines zu dem erfindungsgemäßen Gehäuse gehörenden Verschlußteils und

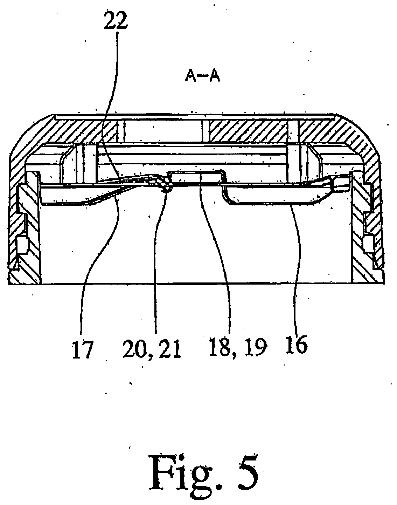

- Fig. 5: einen Schnitt durch das Verschlußteil nach Fig. 4 längs der Linie A-A.

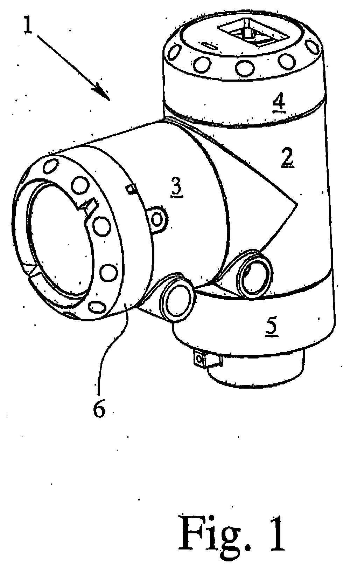

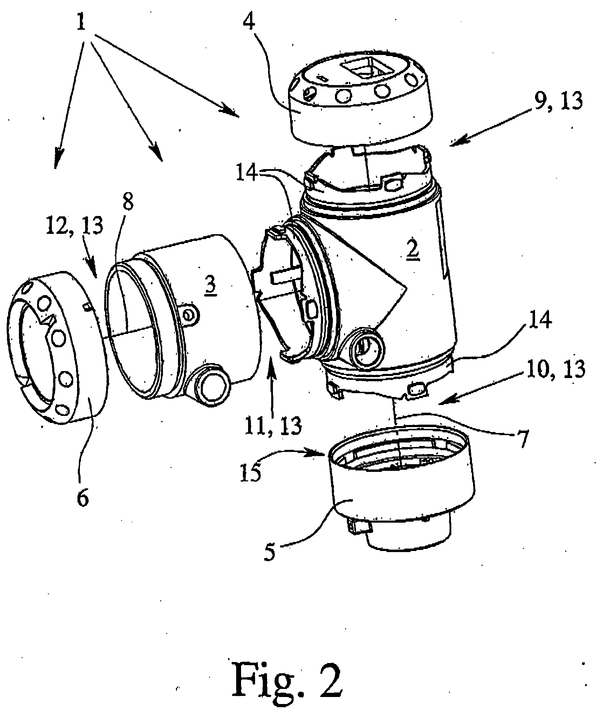

Das in den Fig. 1 und 2 dargestellte Gehäuse 1 ist bestimmt für ein elektrisches oder elektronisches Gerät - oder Bestandteil eines elektrischen oder elektronischen Geräts. Zu dem dargestellten Gehäuse 1 gehören im Ausführungsbeispiel zwei nicht dargestellte elektrische und/oder elektronische Bauelemente, Bauteile, Bauelementegruppen und/oder Bauteilegruppen in ihren Innenräumen aufnehmende Aufnahmeteile 2, 3 und die Aufnahmeteile 2, 3 verschließende Verschlußteile 4, 5 und 6.

In dem in den Fig. 1 und 2 dargestellten Ausführungsbeispiel eines erfindungsgemäßen Gehäuses 1 sind die Aufnahmeteile 2 und 3 zylindrisch ausgeführt; sie weisen Hauptachsen 7 und 8 auf. Das zweite Aufnahmeteil 3 ist mit seiner Hauptachse 8 senkrecht zur Hauptachse 7 des ersten Aufnahmeteils 2 angeordnet; es ist gleichsam domartig auf dem ersten Aufnahmeteil 2 vorgesehen.

Bei dem in den Fig. 1 und 2 dargestellten Ausführungsbeispiel eines erfindungsgemäßen Gehäuses 1 sind, was besonders deutlich der Fig. 2 entnommen werden kann, insgesamt vier Verbindungsstellen 9, 10, 11 und 12 zwischen den Aufnahmeteile 2, 3 und den Verschlußteilen 4, 5, 6 verwirklicht, nämlich die Verbindungsstelle 9 zwischen dem Aufnahmeteil 2 und dem Verschlußteil 4, die Verbindungsstelle 10 zwischen dem Aufnahmeteil 2 und dem Verschlußteil 5, die Verbindungsstelle 11 zwischen den Aufnahmeteilen 2, 3 und die Verbindungsstelle 12 zwischen dem Aufnahmeteil 3 und dem Verschlußteil 6.

Erfindungsgemäß ist zwischen jedem Verschlußteil 4, 5, 6 und jedem Aufnahmeteil 2, 3 sowie zwischen den Aufnahmeteile 2 und 3 ein Bajonettverschluß 13 verwirklicht, wobei jeder Bajonettverschluß 13 einen ersten Bajonettteil 14 und einen zweiten Bajonettteil 15 aufweist. Dazu, wie üblicherweise ein Bajonettverschluß aussieht und verwirklicht ist, wird auf die entsprechenden Ausführungen weiter oben verwiesen.

Bei dem bevorzugten Ausführungsbeispiel eines erfindungsgemäßen Gehäuses 1, das in den Fig. 1 und 2 dargestellt ist, ist ein "besonderer" Bajonettverschluß 13 verwirklicht, nämlich ein solcher, bei dem in der Verbindungsposition immer ein gleicher Spalt realisiert ist, vorzugsweise immer ein Spalt mit der Spaltweite Null.

Erfindungsgemäß weist jeder Bajonettverschluß 13 am ersten Bajonettteil 14 über den Umfang verteilt abwechselnd eine in der Ebene senkrecht zur Steckrichtung senkrecht verlaufende Grundfläche 16, eine sich an die Grundfläche 16 anschließende Schrägfläche 17 und eine sich an das obere Ende der Schrägfläche 17 anschließende, zur Steckrichtung senkrecht verlaufende Kopffläche 18 auf. Der senkrecht zur Steckrichtung verlaufenden Kopffläche 18 am ersten Bajonettteil 14 ist am zweiten Bajonettteil 15 eine senkrecht zur Steckrichtung verlaufende Gegenfläche 19 zugeordnet. In der Verbindungsposition liegt jede Gegenfläche 19 jedes zweiten Bajonetteils 15 an der entsprechenden Kopffläche 18 des ersten Bajonettteils 14 an. Es korrespondieren dann also zwei senkrecht zur Steckrichtung verlaufende Flächen, nämlich die Gegenflächen 19 am zweiten Bajonettteil und die Kopfflächen 18 am ersten Bajonettteil. Daraus resultiert - über den Umfang insgesamt gesehen - immer ein gleicher Spalt, vorzugsweise ein Spalt mit Spaltweite Null.

In der Zeichnung ist insoweit ein bevorzugtes Ausführungsbeispiel eines erfindungsgemäßen Gehäuses 1 dargestellt, als bei jedem ersten Bajonettteil 14 jedes Bajonettverschlusses 13 zwischen den Schrägflächen 17 und den sich anschließenden Kopfflächen 18 eine Rastausnehmung 20 verwirklicht ist, der an dem zweiten Bajonettteil 15 jedes Bajonettverschlusses 13 eine in der Verbindungsposition in die Rastausnehmung 20 des ersten Bajonettteils 14 einrastende Rastnase 21 zugeordnet ist, wobei die Rastnase 21 im Ausführungsbeispiel durch eine Rastfeder 22 belastet ist.

In der Zeichnung ist nicht dargestellt, daß bei einem bevorzugten Ausführungsbeispiel eines erfindungsgemäßen Gehäuses 1 ein Lösen des Bajonettverschlusses 13 bzw. der Bajonettverschlüsse 13 nur durch ein besonderes, dem Verwender des mit einem erfindungsgemäßen Gehäuse 1 versehenen elektrischen oder elektronischen Geräts nicht zur Verfügung stehendes Werkzeug möglich ist. Beispielsweise kann ein solches, dem Verwender des mit einem erfindungsgemäßen Gehäuse 1 versehenen elektrischen oder elektronischen Geräts nicht zur Verfügung stehendes Werkzeug ein solches sein, mit dem gegen die Kraft der Rastfeder 22 die Rastnase 21 aus der Rastausnehmung 20 herausgehoben werden kann.

Nicht dargestellt ist schließlich auch, daß bei einem weiter bevorzugten Ausführungsbeispiel der Rastnase 21 und/oder der Rastfeder 22 mindestens ein elektrischer Kontakt zugeordnet sein kann. Dieser elektrische Kontakt - ein Öffner ein Schließer oder ein Wechsler - kann dann signalisieren, ob an allen Verbindungsstellen, im dargestellten Ausführungsbeispiel also an den Verbindungsstellen 9, 10, 11 und 12, die Verbindungen mit Hilfe der Bajonettverschlüsse 13 tatsächlich einwandfrei realisiert sind.

Wie ausgeführt ist das in den Fig. 1 und 2 dargestellte Ausführungsbeispiel eines erfindungsgemäßen Gehäuses 1 ein solches, das zwei Aufnahmeteile 2 und 3 aufweist. Dieses Gehäuse 1 kann deshalb für ein elektrisches oder elektronisches Gerät verwendet werden, das durch einen modularen Aufbau gekennzeichnet ist, bei dem nämlich in den beiden Aufnahmeteilen 2 und 3 jeweils eine eine eigene Funktionstüchtigkeit aufweisende Funktionseinheit vorgesehen sein kann, beispielsweise einerseits eine Energieversorgungseinheit und andererseits eine Meßeinheit oder eine Meß- und Auswerteeinheit.

## Patentansprüche

1. Gehäuse für ein elektrisches oder elektronisches Gerät mit mindestens zwei - elektrische und/oder elektronische Bauelemente, Bauteile, Bauelementegruppen und/oder Bauteilegruppen in ihren Innenräumen aufnehmende - Aufnahmeteilen und mit mindestens einem mindestens ein Aufnahmeteil verschließenden Verschlussteil, wobei in jedem Aufnahmeteil eine eine eigene Funktionstüchtigkeit aufweisende Funktionseinheit vorgesehen sein kann,
**dadurch gekennzeichnet,**
**dass** zwischen den Aufnahmeteile (2 und 3) sowie zwischen mindestens einem Aufnahmeteil (2, 3) und dem Verschlussteil (4) oder den Verschlussteilen (4, 5) jeweils ein Bajonettverschluss (13) realisiert ist,
**dass** der Bajonettverschluss (13) aus einem ersten Bajonettteil (14) und einem zweiten Bajonettteil (15) besteht,
**dass** der Bajonettverschluss (13) am ersten Bajonettteil (14) über den Umfang verteilt abwechselnd eine in der Ebene senkrecht zur Steckrichtung senkrecht verlaufende Grundfläche (16), eine sich an die Grundfläche (16) anschließende Schrägfläche (17) und eine sich an das obere Ende der Schrägfläche (17) anschließende, zur Steckrichtung senkrecht verlaufende Kopffläche (18) aufweist und
**dass** der senkrecht zur Steckrichtung verlaufenden Kopffläche (18) am ersten Bajonettteil (14) am zweiten Bajonettteil (15) eine senkrecht zur Steckrichtung verlaufende Gegenfläche (19) zugeordnet ist.

2. Gehäuse nach Anspruch 1, **dadurch gekennzeichnet, dass** ein "besonderer" Bajonettverschluss (13) verwirklicht ist, nämlich ein solcher, bei dem in der Verbindungsposition immer ein gleicher Spalt realisiert ist, vorzugsweise immer ein Spalt mit der Spaltweite Null.

3. Gehäuse nach Anspruch 1 oder 2, **dadurch gekennzeichnet, dass** zwischen den Schrägflächen (17) und den sich anschließenden Kopfflächen (18) eine Rastausnehmung (20) verwirklicht ist.

4. Gehäuse nach Anspruch 3, **dadurch gekennzeichnet, dass** an dem zweiten Bajonettteil (15) eine in der Verbindungsposition in die Rastausnehmung (20) des ersten Bajonettteils (14) einrastende Rastnase (21) vorgesehen ist.

5. Gehäuse nach Anspruch 4, **dadurch gekennzeichnet, dass** die Rastnase (21) durch eine Rastfeder (22) belastet ist.

6. Gehäuse nach Anspruch 5, **dadurch gekennzeichnet, dass** ein Lösen des Bajonettverschlusses (13) nur durch ein gegen die Kraft der Rastfeder (22) erfolgendes Herausheben der Rastnase (21) aus der Rastausnehmung (20) möglich ist.

7. Gehäuse nach einem der Ansprüche 4 bis 6, **dadurch gekennzeichnet, dass** ein Lösen des Bajonettverschlusses (13) nur durch ein besonderes, dem Verwender des mit einem Gehäuse nach Anspruch 8 versehenen Geräts nicht zur Verfügung stehendes Werkzeug möglich ist.

8. Gehäuse nach einem der Ansprüche 4 bis 7, **dadurch gekennzeichnet, dass** der Rastnase (21) und/oder der Rastfeder (22) mindestens ein elektrischer Kontakt zugeordnet ist, - ein Schließer, ein Öffner oder ein Wechsler.

## Claims

1. Housing for an electric or electronic device having at least two receiving parts - accommodating electric and/or electronic components, parts, component groups and/or parts groups in its interior - and with at least one locking part closing the receiving part, wherein one functional unit having its own functionality can be provided in each receiving part,
**characterized in**
**that** a bayonet connector (13) is realized between the receiving parts (2 and 3) as well as between at least one receiving part (2, 3) and the locking part (4) or the locking parts (4, 5),
**that** the bayonet connector (13) consists of a first bayonet part (14) and a second bayonet part (15),
**that** the bayonet connector (13) has a base (16) perpendicular in the plane running perpendicular to the direction of insertion, a diagonal surface (17) connecting to the base (16) and a head (18) running perpendicular to the direction of insertion connecting to the upper end of the diagonal surface (17) distributed alternately over the entirety on the first bayonet part (14),
**that** the head (18) running perpendicular to the insertion direction on the first bayonet part (14) is assigned an opposing surface (19) running perpendicular to the direction of insertion on the second bayonet part (15).

2. Housing according to claim 1, **characterized in that** a "special" bayonet connector (13) is realized, namely one, in which a uniform gap is always realized in the connected position, preferably always a gap with a gap width of zero.

3. Housing according to claim 1 or 2, **characterized in that** a latch recess (20) is realized between the diagonal surfaces (17) and the heads (18) attached thereto.

4. Housing according to claim 3, **characterized in that** a latch (21) is provided on the second bayonet part (15) that latches into the latch recess (20) of the first bayonet part (14) in the connected position.

5. Housing according to claim 4, **characterized in that** the latch (21) is loaded by a latch spring (22).

6. Housing according to claim 5, **characterized in that** it is only possible to release the bayonet connector (13) by lifting the latch (21) out of the latch recess (20) against the force of the latch spring (22).

7. Housing according to any one of claims 4 to 6, **characterized in that** releasing the bayonet connector (13) is only possible using a special tool that is not available to the user of a device provided with the housing according to claim 6.

8. Housing according to any one of claim 4 to 7, **characterized in that** the latch (21) and/or the latch spring (22) is assigned at least one electric contact - a break contact, a make contact or a changeover contact.

## Revendications

1. Boîtier pour un appareil électrique ou électronique comprenant au moins deux parties de réception recevant dans leurs espaces intérieurs des éléments modulaires électriques et/ou électroniques, des composants, des groupes d'éléments modulaires et/ou des groupes de composants, et comprenant au moins une partie de fermeture fermant au moins une partie de réception, une unité fonctionnelle présentant sa propre fonctionnalité pouvant être prévue dans chaque partie de réception,
**caractérisé en ce que**
entre les parties de réception (2 et 3) ainsi qu'entre au moins une partie de réception (2, 3) et la partie de fermeture (4) ou les parties de fermeture (4, 5), est à chaque fois réalisée une fermeture à baïonnette (13),
la fermeture à baïonnette (13) se compose d'une première partie de baïonnette (14) et d'une deuxième partie de baïonnette (15),
la fermeture à baïonnette (13) présente au niveau de la première partie de baïonnette (14) et réparties en alternance sur la périphérie, une surface de base (16) s'étendant perpendiculairement dans le plan perpendiculaire à la direction d'enfichage, une surface oblique (17) se raccordant à la surface de base (16) et une surface de tête (18) s'étendant perpendiculairement à la direction d'enfichage et se raccordant à l'extrémité supérieure de la surface oblique (17), et
la surface de tête (18) s'étendant perpendiculairement à la direction d'enfichage au niveau de la première partie de baïonnette (14) étant associée au niveau de la deuxième partie de baïonnette (15) à une surface conjuguée (19) s'étendant perpendiculairement à la direction d'enfichage.

2. Boîtier selon la revendication 1, **caractérisé en ce qu'**une fermeture à baïonnette (13) "spéciale" est réalisée, à savoir une fermeture dans laquelle une fente identique est toujours réalisée dans la position de connexion, de préférence une fente de largeur nulle.

3. Boîtier selon la revendication 1 ou 2, **caractérisé en ce qu'**entre les surfaces obliques (17) et les surfaces de tête s'y raccordant (18) est réalisé un évidement d'encliquetage (20).

4. Boîtier selon la revendication 3, **caractérisé en ce qu'**un ergot d'encliquetage (21) s'encliquetant dans l'évidement d'encliquetage (20) de la première partie de baïonnette (14) dans la position de connexion est prévu au niveau de la deuxième partie de baïonnette (15).

5. Boîtier selon la revendication 4, **caractérisé en ce que** l'ergot d'encliquetage (21) est sollicité par un ressort d'encliquetage (22).

6. Boîtier selon la revendication 5, **caractérisé en ce qu'**un desserrage de la fermeture à baïonnette (13) n'est possible que par un soulèvement de l'ergot d'encliquetage (21) hors de l'évidement d'encliquetage (20) se produisant à l'encontre de la force du ressort d'encliquetage (22).

7. Boîtier selon l'une quelconque des revendications 4 à 6, **caractérisé en ce qu'**un desserrage de la fermeture à baïonnette (13) n'est possible que par un outil spécial non disponible pour l'utilisateur de l'appareil pourvu d'un boîtier selon la revendication 8.

8. Boîtier selon l'une quelconque des revendications 4 à 7, **caractérisé en ce qu'**au moins un contact électrique - un contact fermeture, un contact ouverture ou un inverseur - est associé à l'ergot d'encliquetage (21) et/ou au ressort d'encliquetage (22).
